# EUROPEAN PATENT APPLICATION

(11) **EP 3 992 596 A1**
(43) Date of publication of application: **04.05.2022**
(21) Application number: 21204446.5
(22) Date of filing: 25.10.2021
(51) Int. Cl.: G01J 1/04, G01S 7/481, G01S 17/894

(54) **OPTICAL ELEMENT, OPTICAL DEVICE, DISTANCE MEASUREMENT APPARATUS, AND MOBILE OBJECT**

(30) Priority: 30.10.2020 JP 2020182988; 10.09.2021 JP 2021147889; 19.10.2021 JP 2021171174
(71) Applicant: Ricoh Company, Ltd., Tokyo 143-8555 (JP)
(72) Inventor: SATOH, Takumi, Tokyo, 143-8555 (JP); OKA, Yuuki, Tokyo, 143-8555 (JP)
(74) Representative: J A Kemp LLP

(57) **Abstract**

An optical element (12) includes a first surface (120a); and a second surface (120b) facing the first surface (120a); a light-transmissive portion (121) to transmit and diverge a light beam incident on the light-transmissive portion (121) from outside of the first surface (120a) to emit a diverging light beam to outside of the second surface (120b); and a light-deflecting portion (122) to deflect a light beam incident on the first surface (120a) from the outside of the first surface (120a), in a direction different from a direction of specular reflection on the first surface (120) outside the first surface (120a).

## Description

### BACKGROUND

### Technical Field

The present disclosure relates to an optical element, an optical device, a distance measurement apparatus, and a mobile object.

### Related Art

Optical elements such as glass lids serving as a lid of a package that houses a light emitting element are conventionally known.

Japanese Patent No. 6019552 discloses the configuration in which an optical element such as a glass lid is tilted to reflect some rays of light emitted from the light emitter toward the photosensor so as to detect the fluctuations in the light intensity of the light emitter due to rays emitted from the light emitter and reflected by the optical element back to the light emitters.

This configuration, however, causes an increase in the size of the optical device including the light source and the optical element because of the tilt of the optical element.

### SUMMARY

In view of the above circumstances, the present disclosure aims at achieving an optical element that allows a decrease in the size of the optical device.

An optical element includes a first surface; and a second surface facing the first surface; a light-transmissive portion to transmit and diverge a light beam incident on the light-transmissive portion from outside of the first surface to emit a diverging light beam to outside of the second surface; and a light-deflecting portion to deflect a light beam incident on the first surface from the outside of the first surface, in a direction different from a direction of specular reflection on the first surface outside the first surface.

At least one embodiment of the present disclosure provides an optical element that achieves a reduction in the size of the optical device.

### BRIEF DESCRIPTION OF THE SEVERAL VIEWS OF THE DRAWINGS

A more complete appreciation of the disclosure and many of the attendant advantages and features thereof can be readily obtained and understood from the following detailed description with reference to the accompanying drawings, wherein:
FIG. 1 is a block diagram of a distance measurement apparatus according to an embodiment;
FIG. 2 is a cross-sectional view of an exemplary configuration of a light source device according to a first embodiment;
FIGs. 3A and 3B are exploded views of a configuration of the light source device according to the first embodiment, FIG. 3A being a plan view of a glass lid and FIG. 3B being a plan view of an electrical board;
FIGs. 4A and 4B are exploded views of a light source device according to a first variation of the first embodiment, FIG. 4A being a plan view of a glass lid and FIG. 4B being a plan view of an electrical board;
FIGs. 5A and 5B are exploded views of a light source device according to a second variation of the first embodiment, FIG. 5A being a plan view of a glass lid and FIG. 5B being a plan view of an electrical board;
FIG. 6 is a cross-sectional view taken along line A-A in FIGs. 5A and 5B;
FIG. 7 is a cross-sectional view of a configuration of a VCSEL according to an embodiment;
FIGs. 8A to 8F are illustrations of different examples of the diverging action of the light-transmissive portion, FIG. 8A being an illustration of a first example, FIG. 8B being an illustration of a second example, FIG. 8C being an illustration of a third example, FIG. 8D being an illustration of a fourth example, FIG.8E being an illustration of a fifth example, and FIG. 8F being an illustration of a sixth example;
FIGs. 9A, 9B, and 9C are cross-sectional views of different exemplary configurations of the DOE according to embodiments, FIG. 9A being an illustration of a first example, FIG. 9B being an illustration of a second example, and FIG. 9C being an illustration of a third example;
FIGs. 10A, 10B, and 10C are illustrations of a first exemplary configuration of a light-deflecting portion according to an embodiment, FIG. 10A illustrating the deflection of the light-deflecting portion, FIG. 10B being a top view of the light-deflecting portion, and FIG. 10C being a cross-sectional view of the light-deflecting portion;
FIGs. 11A, 11B, and 11C are illustrations of a second exemplary configuration of a light-deflecting portion according to an embodiment, FIG. 11A illustrating the deflection of the light-deflecting portion, FIG. 11B being a top view of the light-deflecting portion, and FIG. 11C being a cross-sectional view of the light-deflecting portion;
FIGs. 12A and 12B are illustrations of an exemplary configuration of a light-transmissive portion according to an embodiment, FIG. 12A illustrating divergence of the light-transmissive portion and FIG. 12B being a top view of the light-transmissive portion;
FIGs. 13A to 13E are illustrations of processes of manufacturing a DOE according to an embodiment;
FIGs. 14A and 14B are illustrations of the relation between the offset amount of the glass lid and the diffraction efficiency, FIG. 14A illustrating the deflection of the light-deflecting portion and FIG. 14B being a graph of the diffraction efficiency;
FIG. 15 is a cross-sectional view of an exemplary configuration of a light source device according to a second embodiment;
FIGs. 16A and 16B are cross-sectional views of an exemplary configuration of the light source device, FIG. 16A being a plan view of a glass lid and FIG. 16B being a plan view of an electrical board;
FIG. 17 is a cross-sectional view example of a light source device according to a first variation of the second embodiment;
FIGs. 18A and 18B are exploded views of a configuration of a light source device according to an embodiment, FIG. 18A being a plan view of a glass lid and FIG. 18B being a plan view of an electrical board;
FIGs. 19A and 19B are exploded views of a configuration of a light source device according to a second variation of the second embodiment, FIG. 19A being a plan view of a glass lid and FIG. 19B being a plan view of an electrical board;
FIG. 20 is an illustration of a change in voltage detected by a photosensor during the regular operation mode of the light source device;
FIG. 21 is an illustration of a change in voltage detected by the PD during the abnormal operation mode of the light source device;
FIG. 22 is an illustration of a first example of divergence of laser beams emitted from the light source device according to the third embodiment;
FIG. 23 is an illustration of a second example of divergence of laser beams emitted from the light source device according to the third embodiment;
FIG. 24 is an illustration of a light source device according to a fourth embodiment;
FIG. 25 is an illustration of a light source device according to a first variation of the fourth embodiment;
FIG. 26 is an illustration of a light source device according to a second variation of the fourth embodiment; and
FIG. 27 is an illustration of a mobile object according to a fifth embodiment.

The accompanying drawings are intended to depict embodiments of the present invention and should not be interpreted to limit the scope thereof. The accompanying drawings are not to be considered as drawn to scale unless explicitly noted. Also, identical or similar reference numerals designate identical or similar components throughout the several views.

### DETAILED DESCRIPTION

In describing embodiments illustrated in the drawings, specific terminology is employed for the sake of clarity. However, the disclosure of this specification is not intended to be limited to the specific terminology so selected and it is to be understood that each specific element includes all technical equivalents that have a similar function, operate in a similar manner, and achieve a similar result.

Referring now to the drawings, embodiments of the present disclosure are described below. As used herein, the singular forms "a," "an," and "the" are intended to include the plural forms as well, unless the context clearly indicates otherwise.

Embodiments of the present invention include a light deflector that deflects light to a photosensor to allow the photosensor to receive the light, which eliminates the need for tilting the optical element to detect fluctuations in the light intensity of the light emitters and achieves a compact light source device with an optical element.

Hereinafter, an embodiment will be described using a distance measurement apparatus incorporating a light source device provided with light-emitting elements and an optical element according to at least embodiment. In the drawings described below, an X-direction is a predetermined direction within a plane parallel to a plane of an electrical board on which light-emitting elements are mounted, a Y-direction is orthogonal to the X-direction within the plane parallel to the plane of the electrical board, and a Z-direction is orthogonal to both the X-direction and the Y-direction. The light-emitting elements emit light along the Z-direction, and the distance measurement apparatus projects light along the Z-direction. However, these directions are for convenience of description, and there is no particular limitation on the directions of the optical element, the optical device, and the distance measurement apparatus, and each of the optical element, the optical device, and the distance measurement apparatus are arranged in any direction.

### First Embodiment

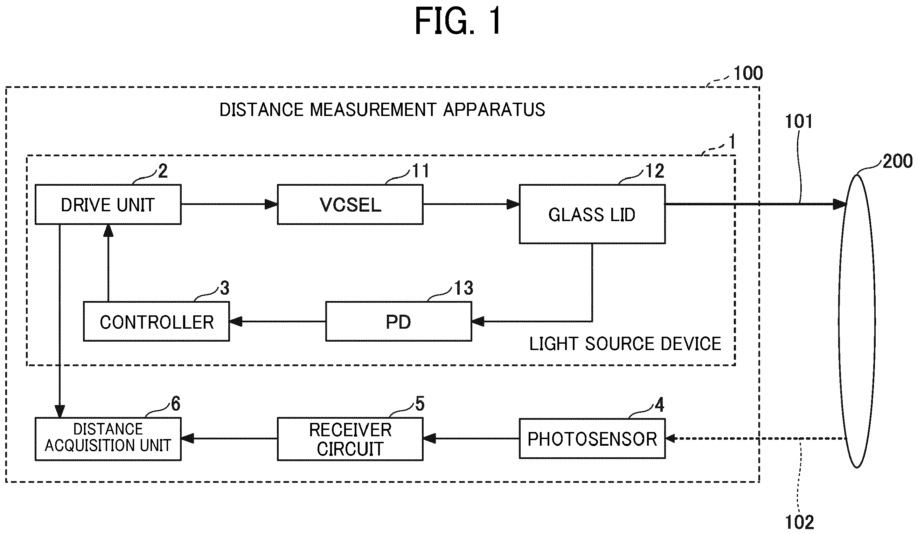

First, a distance measurement apparatus according to a first embodiment will be described. FIG. 1 is a block diagram of an overall configuration of a distance measurement apparatus 100 according to an embodiment. As illustrated in FIG. 1, the distance measurement apparatus 100 includes a light source device 1, a photosensor 4, a receiver circuit 5, and a distance acquisition unit 6.

The distance measurement apparatus 100 projects light (i.e., a projected laser beam 101) emitted by the light source device 1 to an object 200, and receives light (i.e., return light 102) reflected or scattered from the object 200. The distance measurement apparatus 100 uses the time of flight (TOF) that measures a distance to the object 200 based on the timing of light emission of the laser beam 101 and the timing of light reception of the return light 102 from the object 200.

The distance measurement apparatus 100 is also referred to as a position-measuring apparatus to measure a position of the object 200 that is present in the direction (i.e., the direction of light emission) in which the laser beam 101 is projected of emitted from the light source device 1. The projected laser beam 101 is flash spreading or diverging in a direction intersecting the direction of emission of the laser beam 101, which allows measurement of the position of the object 200 in the direction intersecting the direction of emission of the laser beam 101. The distance measurement apparatus 100 measures a three-dimensional position of the object 200 using such laser beams from the light source device 1 and is referred to also as a three-dimensional position measuring apparatus.

The light source device 1 is an example of an optical device that emits light and includes a vertical cavity surface-emitting laser (VCSEL) 11, a glass lid 12, a photo diode (PD) 13, a driver 2, and a controller 3.

The VCSEL 11, which is an example of a light source, is a vertical cavity surface-emitting laser (i.e., a surface-emitting laser) that emits a laser beam in a direction perpendicular to its surface. The VCSEL 11 includes multiple VCSEL elements 11-1, 11-2, ... 11-n. The VCSEL element is an example of a light-emitting element. The light source is not limited to the VCSEL 11 and may be a light emitting diode (LED), or an edge emitting semiconductor laser (LD) (i.e., an edge-emitting laser). The laser beam is an example of light emitted by the light source, and the light emitted by the light source is not limited to the laser beam and may be incoherent light such as white light.

The glass lid 12 is a flat plate member containing glass material that allows laser beams emitted from the VCSEL 11 to pass through the glass lid 12. The glass lid 12 is an example of an optical element and includes a light-transmissive portion and a light-deflecting portion. The light-transmissive portion allows some rays of incident light from the VCSEL 11 to pass through the glass lid 12. The light-deflecting portion allows some rays of the incident light to deflect. However, the optical element is not limited to the flat-plate glass lid 12, and may have a plane of any shape, such as a curved plane, other than a flat plane. Further, the optical element may contain material such as resin other than glass.

The PD 13, which is an example of a photosensor, receives some rays deflected by the light-deflecting portion of the glass lid 12 among a laser beam emitted from the VCSEL 11 and incident on the glass lid 12 and output an electrical signal according to the light level of some rays received. However, the photosensor is not limited to the PD 13, and may be any device that outputs an electrical signal according to the light level of the received light.

The drive unit 2 is an electric circuit for applying a drive voltage to the VCSEL 11, and the controller 3 is an electric circuit for controlling the driving of the VCSEL 11 by the drive unit 2. The photosensor 4, which is a light-receiving element, receives the return light 102 and outputs an electrical signal according to the light level of the received return light 102.

The receiver circuit 5, which is an electric circuit, amplifies an analog electrical signal output from the photosensor 4 and converts the analog electrical signal into a digital electrical signal through the analog/digital (A/D) conversion. The distance acquisition unit 6, which is an electric circuit, obtains distance information, i.e., a distance between the object 200 and the distance measurement apparatus 100 based on the digital electrical signal indicating the light-reception timing output from the receiver circuit 5 and the electrical signal indicating the light-emission timing output from the drive unit 2.

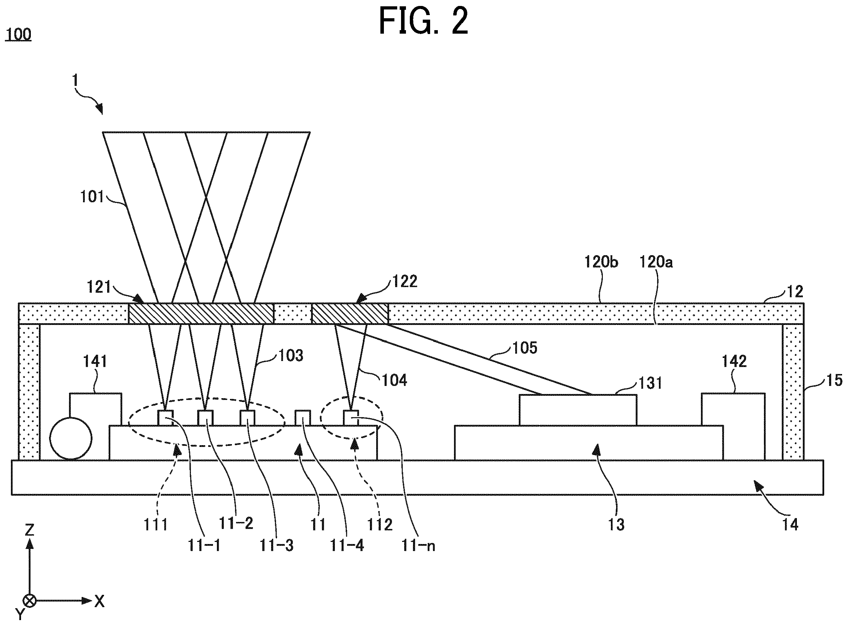

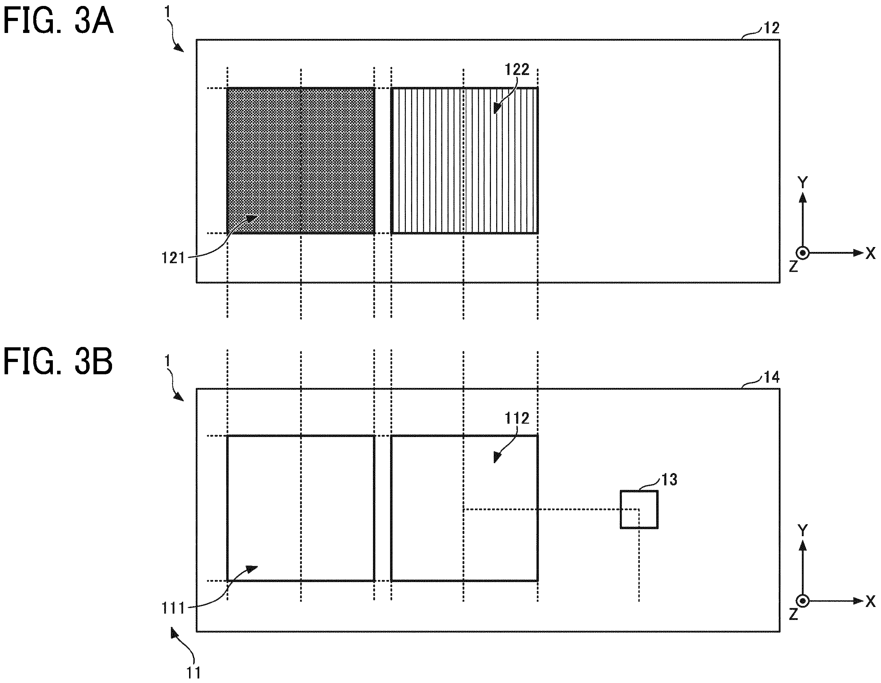

Next, the configuration of the light source device 1 is described with reference to FIGs. 2, 3A, and 3B. FIG. 2 is a cross-sectional view of an exemplary configuration of the light source device 1. FIGs. 3A and 3B are exploded views of a configuration of the light source 1 device according to an embodiment, FIG. 3A being a plan view of the glass lid 12 and FIG. 3B being a plan view of an electrical board 14.

As illustrated in FIG. 2, the light source device 1 includes the glass lid 12, the electrical board 14, and a side wall 15. The VCSEL 11 and the PD 13 are mounted on the +Z-surface of the electrical board 14. The VCSEL 11 is electrically connected to the electrical board 14 through the wiring 141, and the PD 13 is electrically connected to the electrical board 14 through the wiring 142.

The VCSEL 11 and the PD 13 are surrounded by the side wall 15, which is fixed onto the +Z-surface of the electrical board 14. The glass lid 12 has ends fixed to the end faces of the side wall 15 onto the +Z-surface of the electric board 14. The side wall 15 and the glass lid 12 constitute a package housing the VCSEL 11 and the PD 13, and the glass lid 12 serves as a cover of the package. The glass lid 12 includes a light-transmissive portion 121 and a light-deflecting portion 122, which are hatched areas in FIG. 2. In some examples, the light-transmissive portion 121 and the light-deflecting portion 122 are within the same plane of the glass lid 12. Alternatively, the light-transmissive portion 121 and the light-deflecting portion 122 are at different planes of the glass lid 12. Still alternatively, at least one of the light-transmissive portion 121 and the light-deflecting portion 122 is in the interior of the glass lid 12. The light-transmissive portion 121 may be provided on both a first surface 120a and a second surface 120b. Among multiple light-emitting elements included in the VCSEL 11, a group of light-emitting elements that emit light to be incident on the light-transmissive portion 121 is a first light emitters 111, and a group of light-emitting elements that emit light to be incident on the light-deflecting portion 122 is a second light emitters 112. In other words, each of the first light emitter 111 and the second light emitter 112 includes at least one light-emitting element.

The light-transmissive portion 121 at a portion of the glass lid 12 has a periodic structure and serves to transmit and diffract laser beams 103 emitted from the VCSEL 11 and incident on the light-transmissive portion 121. More specifically, the light-transmissive portion 121 diffracts and diverges the laser beams 103 emitted from the first light emitters 111 of the multiple light emitters in the VCSEL 11 and incident on the light-transmissive portion 121. Notably, the diverging of the laser beams 103 by the light-transmissive portion 121 means causing the laser beams to spread. The distance measurement apparatus 100 projects a laser beam 101 that is the laser beams passed through and diverged by the light-transmissive portion 121.

The light-deflecting portion 122 at a portion of the glass lid 12 has a periodic structure and serves to reflect and diffract a laser beam emitted from the VCSEL 11. More specifically, the light-deflecting portion 122 diffracts and deflects a laser beam 104 emitted from the second light emitter 112 and incident on the light-deflecting portion 122, toward a light-receptive surface 131 of the PD 13. The PD 13 receives a laser beam 105 deflected by the light-deflecting portion 122 and outputs an electrical signal according to the light level of the received laser beam. The distance measurement apparatus 100 detects the intensity, or light level of the laser beam emitted from the VCSEL 11 based on the light level of the laser beam 105 received by the PD 13.

In some examples, the light-deflecting portion 122 is fabricated by forming a reflective layer in the glass lid 12 before forming a periodic structure. Alternatively, the light-deflecting portion 122 is fabricated by forming a periodic structure in the glass lid 12 before forming a reflective layer.

As described above, the glass lid 12 serves as a light-transmissive window that is a lid of a package housing a projection optical system, a light-sensing optical system, and the VCSEL 11. The projection optical system diverges and projects a laser beam emitted from the VCSEL 11. The light-sensing optical system detects a light level, or light intensity of the laser beam emitted from the VCSEL 11.

Some rays of the laser beams emitted from the light-emitting elements (i.e., the VCSEL elements) of the VCSEL 11 reflect off the glass lid and return to the light-emitting elements, possibly causing a fluctuation in the light intensities of the laser beams emitted from the light-emitting elements. Such a fluctuation in light intensity causes a fluctuation in the light intensity of the laser beam projected from the distance measurement apparatus, thus degrading the accuracy of measurement. To reduce or eliminate such fluctuations in light intensity due to rays reflected from the glass lid and incident on the light-emitting elements, the glass lid may be tilted to prevent light reflecting off the glass lid from returning to the light-emitting elements. Alternatively, the light intensities of the light-emitting elements may be monitored based on the light intensity of light reflected from the glass lid.

The light source device increases in Z-directional length (i.e., its size) by L × tancp where ϕ denotes a tilt angle of the glass lid relative to a plane (e.g., an XY plane in FIG. 2) on which multiple light emitters are arranged in the VCSEL, L denotes the length of the glass lid in the direction intersecting the direction of projection (i.e., the length in the Z-direction in FIG. 2).

As illustrated in FIG. 2, the light source device 1 includes the glass lid 12 provided with the light-transmissive portion 121 and the light-deflecting portion 122 and causes the laser beam 105 deflected by the light-deflecting portion 122 to reach the light-receptive surface 131 of the PD 13.

In other words, in the present embodiment as illustrated in FIG. 2, the glass lid 12, which is an optical element, includes a first surface 120a and a second surface 120b facing each other. The glass lid 12 includes a light-transmissive portion 121 and a light-deflecting portion 122. The light-transmissive portion 121 transmits and diverges the laser beams 103 incident on the light-transmissive portion 121 from outside of the first surface 120a to emit a diverging laser beam 101 to outside of the second surface 120b. The light-deflecting portion 122 deflects the laser beam 104 incident on the light-deflecting portion 122 from the outside of the first surface 120a, in a direction different from the direction of specular reflection on the first surface 120a outside the first surface 120a.

This configuration eliminates the need to tilt the glass lid 12 in the light source device 1 and thus reduces or prevents an increase in the size of the light source device 1. The light-transmissive portion 121 of the glass lid 12 has an optical property to diverge incident light beams, which reduces return rays emitted from the light-emitting elements (i.e., the VCSEL 11) and reflected from the glass lid 12 back to the light-emitting elements. In the light source device 1, however, the glass lid 12 may be tilted to shift the direction of specular reflection of the rays incident on the light-transmissive portion 121 of the glass lid 12 to any direction other than the direction back to the light-emitting element, so as to prevent or reduce the rays reflected by the light-transmissive portion 121 from returning to the light-emitting elements.

Among the light emitters of the VCSEL 11, any desired light emitter or light emitters are selected to emit a laser beam. In the present embodiment, the light emitters of the VCSEL 11 are categorized into a first light emitter 111 to emit light to be projected from the light source device 1 and a second light emitter 112 to emit light to be used for detecting a fluctuation in light level (e.g., light intensity). Notably, the light-emitting elements serving as the same type of light emitter are driven by the common electrode or driven by the individual electrodes. The second light emitter 112 in which the light-emitting elements are driven by the individual electrodes, for example, allows a selection of some light-emitting elements to be used for detecting the light level.

In the present embodiment as illustrated in FIGs. 3A and 3B, the first light emitter 111, the second light emitters 112, and the PD 13 are sequentially arranged along the X-direction (i.e., the X-axis). The distance between the VCSEL 11 and the glass lid 12 in the Z-direction (i.e., along the Z-axis) is 1 mm. The light-transmissive portion 121 diverges an incident laser beam from the VCSEL 11 at an angle of 100 degrees in the X-direction and at an angle of 70 degrees in the Y-direction.

The light-deflecting portion 122 deflects an incident laser beam from the VCSEL 11 toward the center of the PD 13, which is in the direction tilted by an angle of 50 degrees with respect to the XY plane. Then, the deflected laser beam comes to hit the light-receptive surface of the PD 13 whose center is 1.2 mm apart from the center of the second light emitter 112 in the X-direction.

The controller detects the light level, or light intensity of the VCSEL 11 based on the electrical signal output from the PD 13 and controls the driver 2 to adjust the drive voltage for the VCSEL 11 according to the detected light intensity, thus achieving stabilization of the light intensity of the laser beam 101 projected from the light source device 1.

The present embodiment allows rays, or noise emitted from the VCSEL 11 and reflected from the glass lid 12 to less likely hit the PD 13, thus achieving a higher accuracy of detection of the light intensity of the VCSEL 11 using the PD 13. This enables a high accuracy of control of the light intensity of the VCSEL 11.

FIGs. 2 and 3A and 3B indicate an exemplary configuration of the light source device 1, and the positions of the VCSEL 11 and the PD 13 and the angle of deflection of light from the glass lid 12 are appropriately determined according to the application. In a first variation of the first embodiment to be described later, the second emitter 112 has a smaller area than the first light emitter 111. In a second variation of the first embodiment, multiple reflective and diffractive optical elements (DOEs) are used to deflect the laser beams from the multiple second light emitters 112 to detect the light intensity of the laser beam emitted from the VCSEL 11.

Notably, the DOE is a diffractive optical element that diffracts incident light and propagates the diffracted light in any desired direction. The DOE has a fine periodic structure formed on the surface of a substrate made of, for example, glass, which changes an angle of deflection of diffracted light according to the shape of the periodic structure. The DOE allows the control of the distribution of diffracted light (i.e., the light distribution characteristics) by forming multiple dots or line pattern on its surface or irradiating any desired shaped surface with light uniformly. The light distribution characteristics refer to a brightness, or a light intensity in each direction of projection.

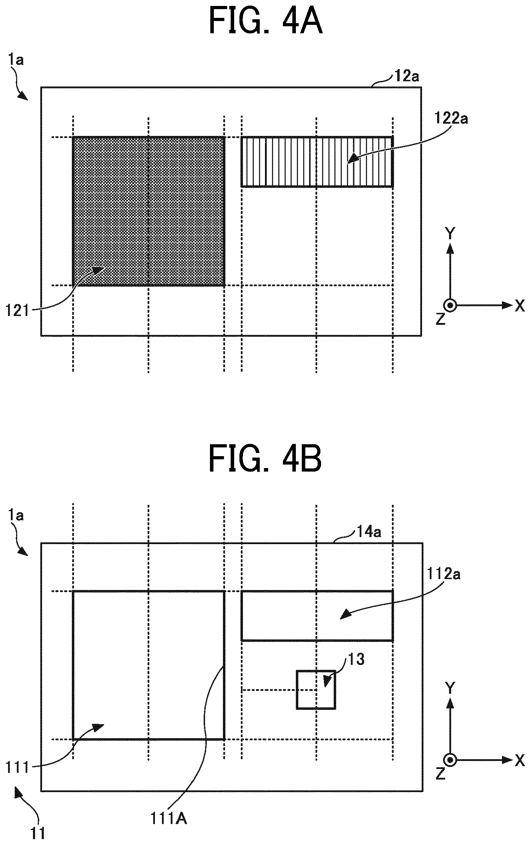

Next, the configuration of a light source device 1a according to a first variation of the first embodiment is described with reference to FIGs. 4A and 4B. FIGs. 4A and 4B are exploded views of the light source device 1a according to the first variation of the first embodiment. FIG. 4A is a plan view of a glass lid 12a, and FIG. 4B is a plan view of an electrical board 14a. As illustrated in FIGs. 4A and 4B, the light source device 1a includes the glass lid 12a and the electrical board 14a. The glass lid 12a includes a light-deflecting portion 122a, and the electrical board 14a includes a second light emitter 112a.

In the light source device 1a, the area of the light-deflecting portion 122a is half or less of the area of the light-transmissive portion 121, and the area of the second light emitter 112a is half or less of the area of the first light emitter 111. Further, in the light source device 1a, the second light emitter 112a and the PD 13 are arranged close to a side 111A, which is one of the four sides constituting the first light emitter 111. This arrangement reduces the area of the light source device 1a.

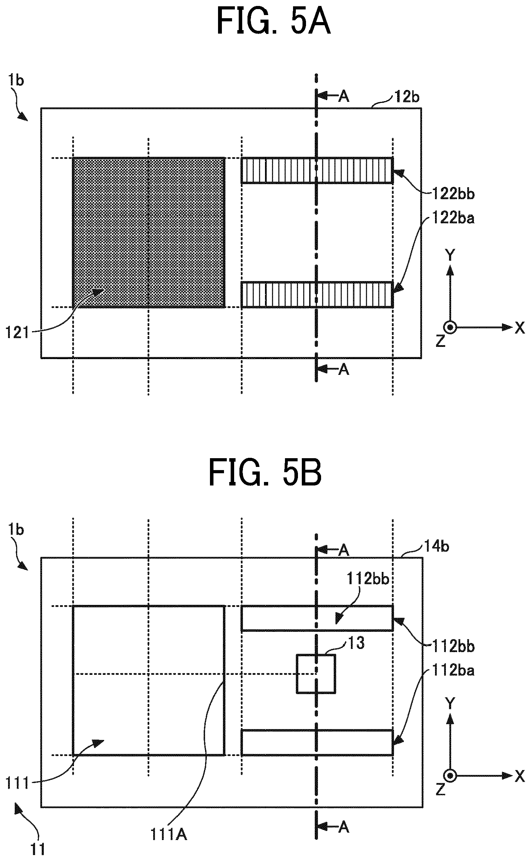

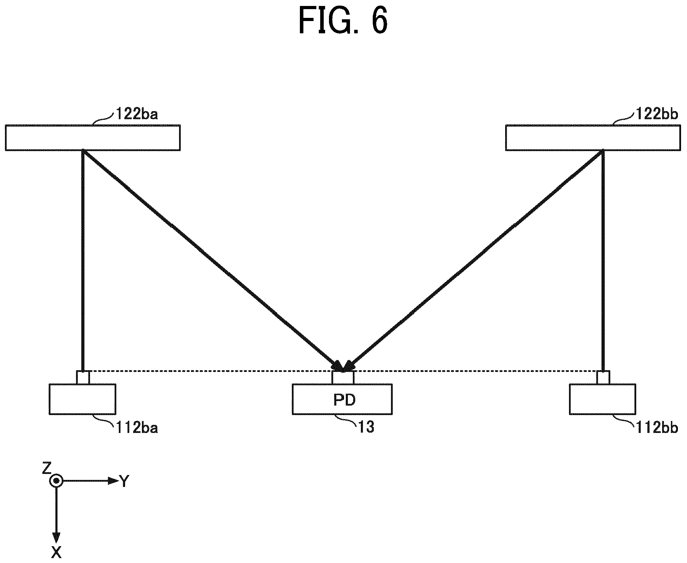

Next, the configuration of a light source device 1b according to a second variation of the first embodiment is described with reference to FIGs. 5A, 5B, and 6. FIGs. 5A and 5B are exploded views of the light source device 1b according to the second variation of the first embodiment. FIG. 5A is a plan view of a glass lid 12b, and FIG. 5B is a plan view of an electrical board 14b. FIG. 6 is a cross-sectional view taken along line A-A in FIGs. 5A and 5B.

As illustrated in FIGs. 5A, 5B, and 6, the light source device 1b includes the glass lid 12b and the electrical board 14b. The glass lid 12b has light-deflecting portions 122ba and 122bb. The electrical board 14b includes second light emitters 112ba and 112bb.

In the light source device 1b, the area of each of the light-deflecting portions 122ba and 122bb is half or less of the area of the light-transmissive portion 121, and the area of each of the second light emitters 112ba and 112bb is half or less of the area of the first light emitter 111.

In the light source device 1b, the second light emitters 112ba and 112bb are arranged symmetrically with respect to the PD 13 in the Y-direction. The PD 13 receives a laser beam emitted from the second light emitter 112ba and deflected by the light-deflecting portion 122ba, and also receives a laser beam emitted from the second light emitter 112bb and deflected by the light-deflecting portion 122bb.

In the light source device 1b, the second light emitters 112ba and 112bb and the PD 13 are arranged close to a side 111A, which is one of the four sides constituting the first light emitter 111. This arrangement reduces the area of the light source device 1a.

To reduce the size of the light source device 1b, each of the second light emitters is to have a smaller area. Further, the second light emitters each preferably emit a laser beam with a light intensity sufficient for the PD 13 to detect. In the present embodiment, two second light emitters 112ba and 112bb are used. Using more second light emitters allows an emission of a laser beam with a light intensity sufficient for the PD 13 to detect. Further, the arrangement of the two second light emitters 112ba and 112bb enables a reduction in the area of the light source device 1.

In some examples, the second light emitters 112ba and 112bb are individually driven.

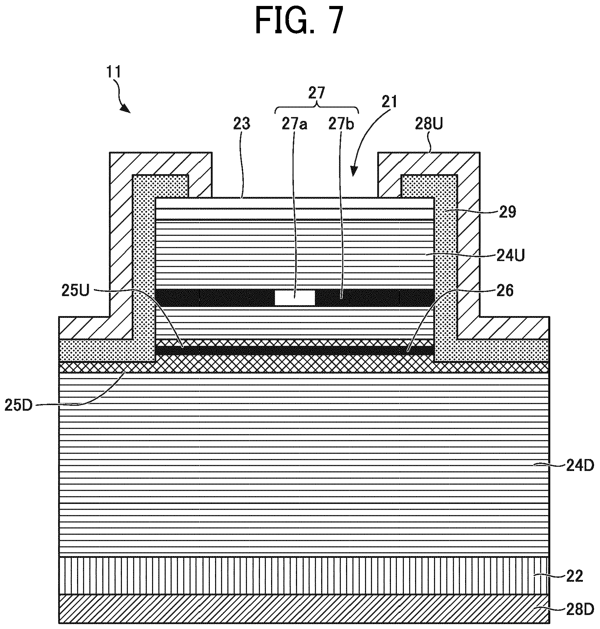

Next, the configuration of the VCSEL11 will be described with reference to FIG. 7. FIG. 7 is an illustration of an exemplary configuration of the VCSEL 11. FIG. 7 indicates a cross-sectional structure of one light emitter of multiple light emitters of the VCSEL 11.

As illustrated in FIG. 7, the VCSEL 11 includes a lower multilayer reflecting mirror 24D, a lower spacer layer 25D, an active layer 26, an upper spacer layer 25U, an upper multilayer reflecting mirror 24U, and a contact layer 23 are stacked in that order on a substrate 22.

In the VCSEL 11, a current confinement layer 27 is formed in the upper multilayer reflecting mirror 24U. The current confinement layer 27 includes a current passing area 27a and a current blocking area 27b enclosing the current passing area 27a. A lower electrode 28D is under the substrate 22, and an upper electrode 28U is on the top of the VCSEL 11. An insulator 29 is disposed to insulate the inner side of the upper electrode 28U. The upper electrode 28U contacts the outer peripheral surface of the contact layer 23, and the central portion of the contact layer 23 is open.

When a current is applied from the upper and lower electrodes 28U and 28D to the active layer 26, a laser beam oscillates after being amplified in the upper multilayer reflecting mirror 24U and the lower multilayer reflecting mirror 24D of the multilayered structure. The emission intensity of the laser beam changes with the applied current. The current confinement layer 27 enhances the efficiency of current application to the active layer 26 to reduce an oscillation threshold. As the current passing area 27a of the current confinement layer 27 increases, a maximum current to be applied increases, which increases a maximum output power of an oscillable laser beam. This, however, increases the oscillation threshold.

The two-dimensional arrangement of the light emitters is more easily achieved by the VCSEL 11 than an edge-emitting laser. Further, the VCSEL 11 provides a multipoint laser in which light emitters are densely arranged. Still further, the surface-emitting laser has a higher degree of flexibility in layout of multiple light emitters, and the light emitters may be arranged at any desired positions on the substrate while meeting the structural restrictions such as arrangement of electrodes.

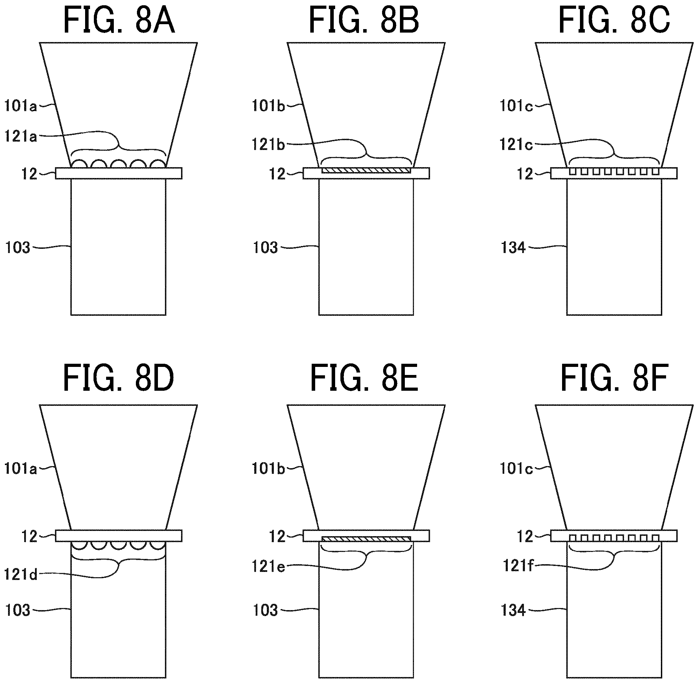

Next, the diverging action of the light-transmissive portion 121 will be described with reference to FIGs. 8A to 8F. FIGs. 8A to 8F are illustrations of different examples of the diverging action of the light-transmissive portion 121. FIG. 8A is an illustration of the diverging action of the light-transmissive portion 121a according to a first example. FIG. 8B is an illustration of the diverging action of the light-transmissive portion 121b according to a second example. FIG. 8C is an illustration of the diverging action of the light-transmissive portion 121c according to a third example. FIG. 8D is an illustration of the diverging action of the light-transmissive portion 121d according to a fourth example. FIG. 8E is an illustration of the diverging action of the light-transmissive portion 121e according to a fifth example. FIG. 8F is an illustration of the diverging action of the light-transmissive portion 121f according to a sixth example.

Examples of the light-transmissive portion 121 formed in or on the glass lid 12 include the light-transmissive portion 121a having multiple microlenses in FIG. 8A, the light-transmissive portion 121d having multiple microlenses in FIG. 8D, the light-transmissive portion 121b having a diverging structure in FIG. 8B, the light-transmissive portion 121e having a diverging structure in FIG. 8E, the light-transmissive portion 121c having a DOE of a periodic structure in FIG. 8C, and the light-transmissive portion 121f having a DOE of a periodic structure in FIG. 8F.

The light-transmissive portions 121a and 121d each have multiple microlenses randomly arranged on the surface of the glass lid 12, which transmits and diverges the laser beam 103 incident on the light-transmissive portion 121a to produce a diverging laser beam 101a. The diverging laser beam 101a refers to a laser beam diverged by the light-transmissive portion 121a or 121d.

The light-transmissive portions 121b and 121e each have a random microstructure included in the surface of the glass lid 12, which allows the laser beam 103 incident on the light-transmissive portion 121a to pass through the light-transmissive portion 121a and diffuses the laser beam passing therethrough using the microstructure to produce a diverging laser beam 101b. The diverging laser beams 101b refers to a laser beam diverged by the light-transmissive portion 121b or 121e.

The light-transmissive portion 121c and 121f each have a transmissive DOE on the surface of the glass lid 12, which allows the laser beam 103 incident on the light-transmissive portion 121a to pass through the light-transmissive portion 121a and diffracts the laser beam passing through the light-transmissive portion 121c using the transmissive DOE to produce a diverging light bream 101c. The diverging laser beam 101c refers to a laser beam diverged by the light-transmissive portion 121c or 121f.

Alternatively, the light-transmissive portion 121 may have multiple microprisms, which transmits and diverges the laser beam 103 incident on the light-transmissive portion 121a using the multiple microprisms to produce a diverging laser beam.

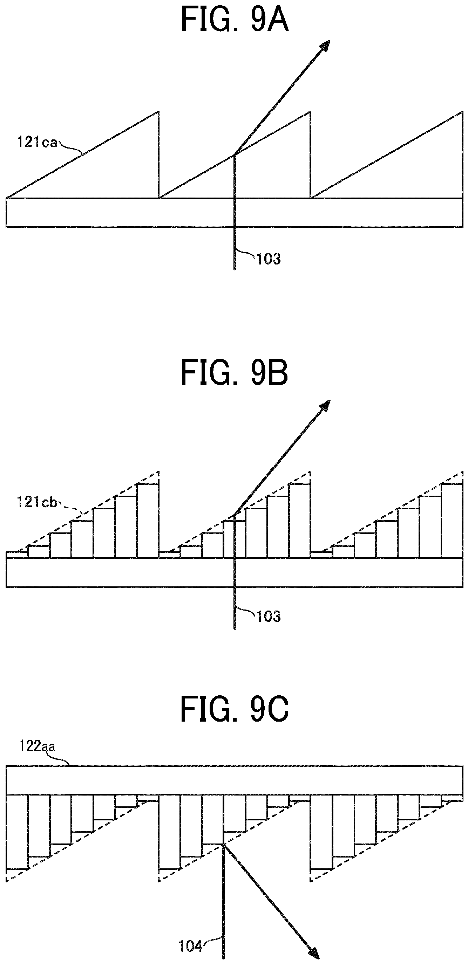

Next, the DOE according to embodiments will be described with reference to FIGs. 9A, 9B, and 9C. FIGs. 9A, 9B, and 9C are cross-sectional views of different exemplary configurations of the DOE. FIG. 9A is an illustration of a DOE according to a first example. FIG. 9B is an illustration of a DOE according to a second example. FIG. 9C is an illustration of a DOE according to a third example.

FIG. 9A indicates a transmissive DOE 121ca having a blazed structure on the second surface 120b of the glass lid 12. More specifically, the transmissive DOE 121ca has a blazed structure having a triangular sawtooth-shaped cross section on the glass lid 12. The diffraction angle is determined by the periodicity of a blazed grating and the tilt of the sloping surface of the blazed structure. In the blazed structure, the maximum diffraction efficiency is obtained at a predetermined diffraction order with respect to light having a predetermined wavelength according the structure.

FIG. 9B is an illustration of the transmissive DOE 121cb having a blazed structure with a stepped grating on the second surface 120b of the glass lid 12. The blazed structure with a stepped grating refers to a blazed structure having its surfaces formed to be substantially stepped. Forming such substantially-stepped surfaces facilitates manufacture of the transmissive DOE 121cb by semiconductor processing using the electron beam (EB) drawing or photolithography, and also exhibits the same diffraction characteristics as those of the blazed structure having sloping surfaces. In the step structure (i.e., the blazed structure with a stepped grating), the diffraction efficiency increases as the number of steps, or gradations of the substantially blazed structure.

FIG. 9C is an illustration of a reflective DOE 122aa having a blazed structure with a stepped grating on the first surface 120a of the glass lid 12. The reflective DOE 122aa is similar to the transmissive DOE 121cb except that the reflective DOE 122aa reflects an incident laser beam 104.

The transmissive DOE 121ca and 121cb in FIGs. 9A and 9B are applicable as the light-transmissive portion 121. The reflective DOE 122aa in FIG. 9C is applicable as the light-deflecting portion 122.

The transmissive DOE 121ca and 121cb transmit and diffract the incident laser beam 103, whereas the reflective DOE 122aa reflects and diffracts the incident laser beam 104. The transmissive DOE 121ca and 121cb may contain material that transmits incident light, and the reflective DOE 122aa may contain material that reflects incident light. The reflective DOE 122aa may be manufactured by applying a reflective film onto a substrate such as glass substrate and forming a periodic microstructure thereon.

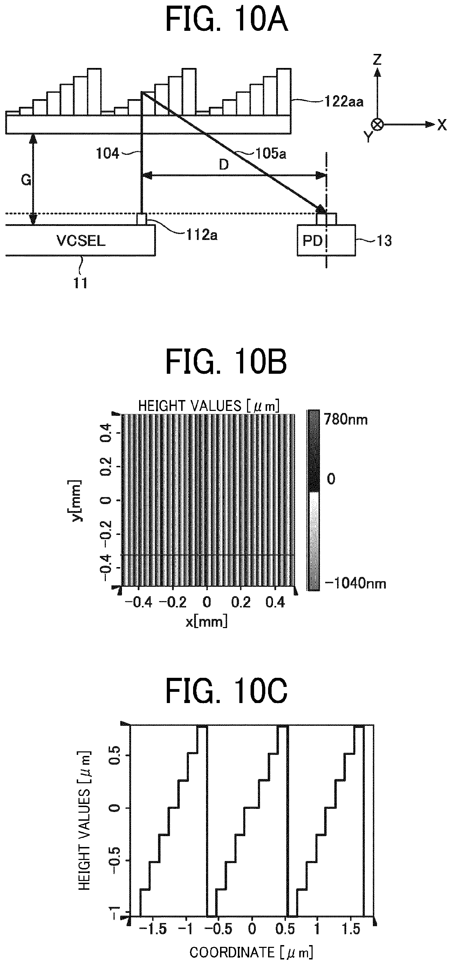

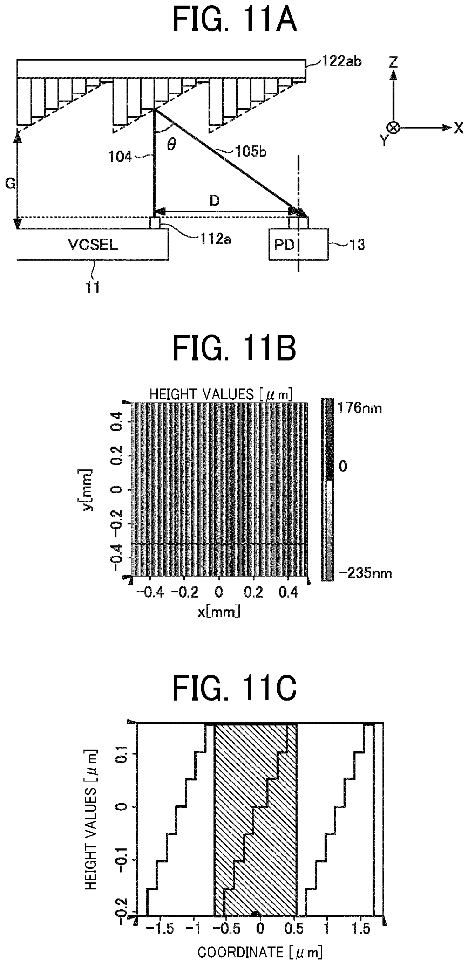

Next, the configuration of the light-deflecting portion will be described with reference to FIGs. 10A, 10B, 10C, 11A, 11B, and 11C. FIGs. 10A, 10B, and 10C are illustrations of the first exemplary configuration of the light-deflecting portion 122aa according to an embodiment, FIG. 10A illustrating the deflection of the light-deflecting portion 122a, FIG. 10B being a top view of the light-deflecting portion 122aa, and FIG. 10C being a cross-sectional view of the light-deflecting portion 122aa.

In FIG. 10A, the distance G between the VCSEL 11 and the light-deflecting portion 122aa is 1 mm, and the light-deflecting portion 122aa is a reflective DOE on the second surface 120b of the glass lid 12 and deflects an incident laser beam having a wavelength 940 nm at a deflection angle θ of 50 degrees. The laser beam 105a deflected by the light-deflecting portion 122aa reaches the center of the light-receptive surface of the PD 13 where a distance D between the center of the light-receptive surface of the PD 13 and the center of the second light emitter 112a is 1.2 mm.

The light-deflecting portion 122aa has the reflective DOE formed on the exit side (i.e., the +Z-side) of the light-deflecting portion 122aa, from which the laser beam 104 emitted from the VCSEL 11 and incident on the light-deflecting portion 122aa exits the light-deflecting portion 122aa. The reflective DOE has a surface coated with a high reflection (HR) coating or a reflective metal film, which deflects the incident laser beam 104 through reflection and diffraction. The light source device 1 includes the light-receptive surface of the PD 13 disposed in the direction of propagation of the deflected laser beam 105a and detects the light intensity of a laser beam emitted from the VCSEL 11 based on an electrical signal output from the PD 13.

FIGs. 10B and 10C are illustrations of an exemplary configuration of the reflective DOE that deflects a laser beam having a wavelength of 940 nm at a deflection angle θ of 50 degrees. The reflective DOE has periodicity on its surface. FIG. 10B indicates the distribution of the height of the +Z-surface of the reflective DOE in the Z-direction within an XY plane, which is indicated by shading. The XY plane refers to a plane on which the periodic structure of the reflective DOE is arranged.

FIG. 10C indicates a cross-sectional shape of the height of the step structure in the Z-direction. The reflective DOE is square 1 mm on a side in the XY plane. The step structure has eight steps with a minimum size of 150 nm within the XY plane, and the periodic structure has a cycle of 1.2 µm within the XY plane. The step structure has a step with a height of 260 nm, and the difference in height between the top and the bottom of the periodic structure is 1.82 µm.

The glass lid 12 is made of quartz glass, and the reflective film is made of material having a higher reflectance to light having a wavelength of 940 nm. The reflective film is, for example, an enhanced reflective film (high-reflective (HR) coating) or a metal film. Although the light-deflecting portion 122aa according to the present embodiment includes the reflective DOE, the light-deflecting portion may include any optical component other than the reflective DOE, such as microlenses, a mirror, a diffusing board, or a prism, that deflects light in any desired direction.

In the light-deflecting portion 122aa in FIGs. 10A, 10B, and 10C, the glass lid 12 has a surface coated with the reflective film. Alternatively, in the light-deflecting portion, a portion of the glass lid 12 serves as a mirror having a high reflectivity to incident light and has a microstructure on the mirror. FIGs. 11A, 11B, and 11C are illustrations of a second exemplary configuration of a light-deflecting portion 122ab. FIG. 11A is an illustration of the deflection of the light-deflecting portion 122ab. FIG. 11B is a top view of the light-deflecting portion 122ab. FIG. 11C is a cross-sectional view of the light-deflecting portion 122ab.

In FIG. 11A, the distance G between the VCSEL 11 and the light-deflecting portion 122ab is 1 mm, and the light-deflecting portion 122ab is a reflective DOE on the first surface 120a of the glass lid 12 and deflects an incident laser beam having a wavelength of 940 nm at a deflection angle θ of 50 degrees. The laser beam 105b deflected by the light-deflecting portion 122ab reaches the center of the light-receptive surface of the PD 13 where a distance D between the center of the light-receptive surface of the PD 13 and the center of the second light emitter 112a is 1.2 mm.

The light-deflecting portion 122ab has the reflective DOE formed on the entrance side (i.e., the -Z-side) of the light-deflecting portion 122ab, on which the laser beam 104 emitted from the VCSEL 11 is incident. The reflective DOE has a surface coated with a high reflection (HR) coating or a reflective metal film, which deflects the incident laser beam 104 through reflection and diffraction. The light source device 1 includes the light-receptive surface of the PD 13 disposed in the direction of propagation of the deflected laser beam 105b and detects the light intensity of a laser beam emitted from the VCSEL 11 based on an electrical signal output from the PD 13.

FIGs. 11B and 11C are illustrations of an exemplary configuration of the reflective DOE that deflects a laser beam having a wavelength of 940 nm at a deflection angle θ of 50 degrees. The reflective DOE has periodicity on its surface. FIG. 11B indicates the distribution of the height of the -Z-surface of the reflective DOE in the Z-direction within an XY plane, which is indicated by shading. FIG. 11C indicates a cross-sectional shape of the height of the step structure in the Z-direction. The reflective DOE is square 1 mm on a side in the XY plane. The step structure has eight steps with a minimum size of 150 nm within the XY plane, and the periodic structure has a cycle of 1.2 µm within the XY plane. The step structure has a step with a height of 58.7 nm, and the difference in height between the top and the bottom of the periodic structure is 411 nm.

In the present embodiment, the light-deflecting portion 122 deflects the incident laser beam 104 by diffraction. Alternatively, the light-deflecting portion 122 may deflects a portion of the incident laser beam by at least one of diffraction, diffusion, and refraction.

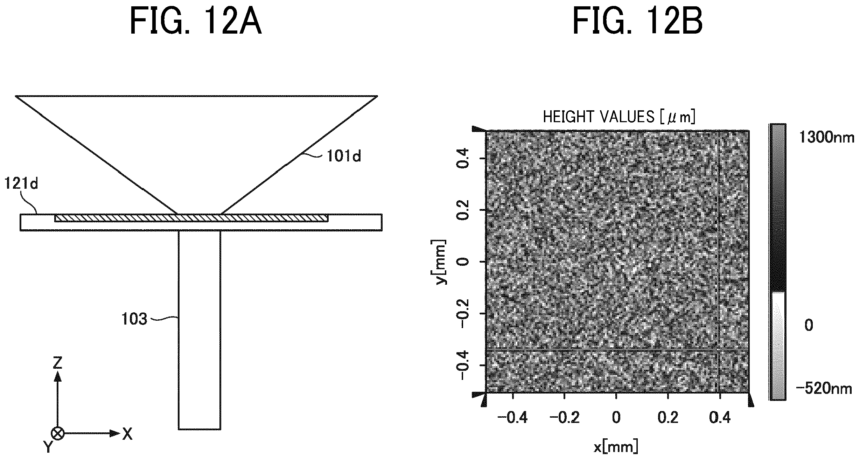

Next, the configuration of a light-transmissive portion according to an embodiment will be described with reference to FIGs. 12A and 12B. FIGs. 12A and 12B are illustrations of an exemplary configuration of a light-transmissive portion 121d according to an embodiment. FIG. 12A is an illustration of divergence of the light-transmissive portion 121d. FIG. 12B is a top view of the light-transmissive portion 121d.

The light-transmissive portion 121d having a transmissive DOE diffracts an incident laser beam having a wavelength of 940 nm. Then, the light-transmissive portion 121d diverges at a divergence angle of 100 degrees in the X-direction and at a divergence angle of 70 degrees in the Y-direction.

The transmissive DOE is square 1 mm on a side in the XY plane. FIG. 12B indicates the distribution of the height of the -Z-surface of the reflective DOE in the -Z-direction within an XY plane, which is indicated by shading. The microstructure has a minimum size of 500 nm within the XY plane and has eight steps. The difference in height between the top and the bottom of the microstructure is 1820 nm.

Although the light-transmissive portion 121d according to the present embodiment includes the transmissive DOE, the light-transmissive portion may include any optical component other than the reflective DOE, such as microlenses, a mirror, a diffusing board, or a prism, that diverges light at any desired angle.

The DOE having the microstructure formed on its surface of an optical material such as glass substrate emits an incident laser beam with any desired intensity distribution. The process of manufacturing such a DOE can use photolithography.

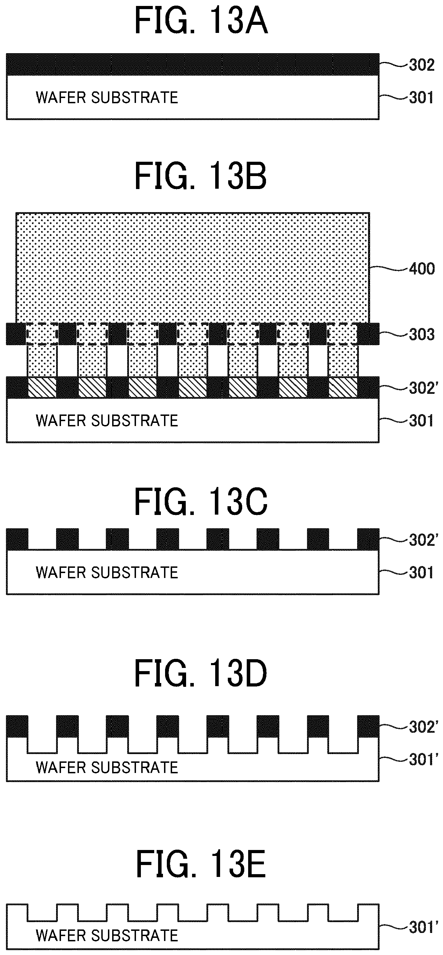

FIGs. 13A to 13E are illustrations of processes of manufacturing a DOE according to an embodiment. FIG. 13A is an illustration of a process of coating a photoresist 302 on a wafer substrate 301. FIG. 13B is an illustration of an exposure process. FIG. 13C is an illustration of a development process. FIG. 13D is an illustration of an etching process. FIG. 13E is an illustration of a resist separation process.

As illustrated in FIG. 13C, a microstructure 302' of the DOE is formed by rendering the photoresist 302 coated on the wafer substrate 301 exposed to the exposure beam 400 using a mask 303 or drawing with a laser beam or an electron beam (EB) thereon.

After that, resist material is separated from the microstructure 302' through the development process and the etching process to obtain a wafer substrate 301' on which a desired DOE structure is formed. The transmission DOE and the reflection DOE provided with the reflection amplification film may be formed on the same plane using semiconductor lithography, and the DOE structure for the light-transmissive portion and the DOE structure for the light-deflecting portion may be formed in parallel on the same flat plate glass lid.

In addition to detecting the light intensity of a laser beam emitted by the VCSEL 11 using the laser beam deflected by the light-deflecting portion 122, the laser beam deflected by the light-deflecting portion 122 may be used to stop the driving of the VCSEL 11 in response to an offset of the glass lid due to some sort of accident.

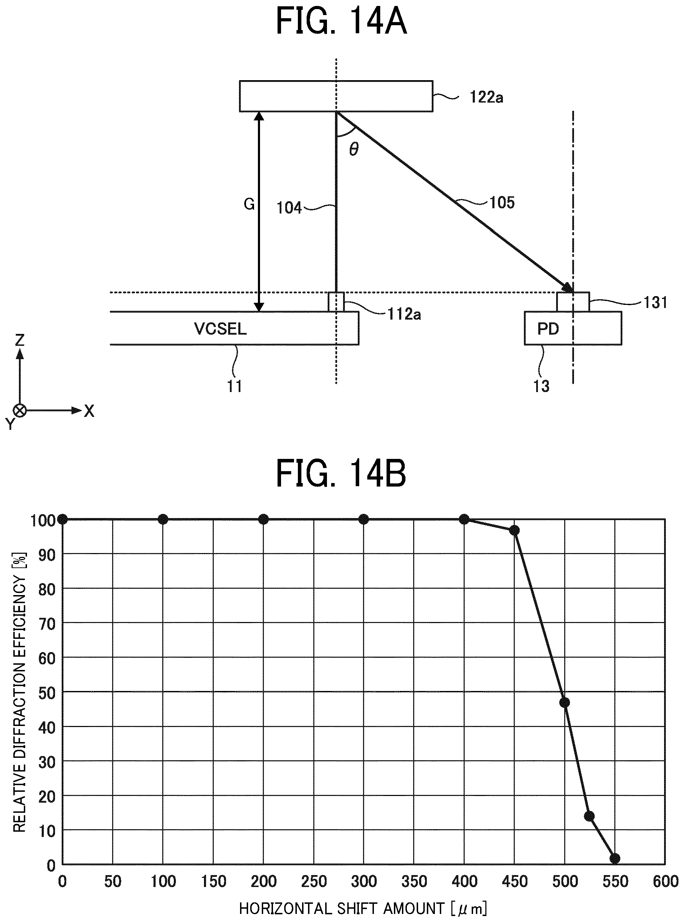

FIGs. 14A and 14B are illustrations of the relation between the offset amount of the glass lid 12 and the diffraction efficiency. FIG. 14A is an illustration of deflection of the light-deflecting portion 122a. FIG. 14B is an illustration of the diffraction efficiency. FIG. 14B indicates the calculation results of changes in relative diffraction efficiency with an offset of the light-deflecting portion 122a in the X-direction, which deflects an incident light at a deflection angle θ of 50 degrees.

The relative diffraction efficiency refers to the ratio between the light intensity of the incident laser beam 104 and the light intensity of the deflected laser beam 105. In the present embodiment, the ratio of the light intensity of the deflected laser beam 105 reaching the PD 13 to the light intensity of the incident laser beam 104 is indicated irrespective of reflection loss.

The computation conditions were as follows: the divergence angle of the incident laser beam 104 was 0 degree (i.e., substantially collimated light), the wavelength was 940 nm, the diameter of the incident laser beam 104 was 100 µm, and the size of the reflective DOE of the light-deflecting portion 122a in the XY plane was 1 mm square.

In addition, the distance G between the second light emitter 112a of the VCSEL 11 and the light-deflecting portion 122a is 1 mm, and the distance between the center of the light-receptive surface 131 of the PD 13 and the center of the second light emitter 112a along the X-axis is 1.2 mm. Further, the light-receptive surface 131 of the PD 13 has a diameter of 200 µm. The offset amount is 0 µm where the center of the light-deflecting portion 122a is substantially coincident with the optical axis of the second light emitter 112a. The light-deflecting portion 122a is rendered offset from the optical axis of the light emitter 112a in the X-direction.

The light-deflecting portion 122a has a periodic structure and deflects laser beams 104 incident on any position of the light-deflecting portion 122a at a deflection angle θ of 50 degrees. As illustrated in FIG. 14B, with an offset amount of 450 µm or less, the relative diffraction efficiency remains unchanged. When an offset amount exceeds 450 µm, the relative diffraction efficiency gradually decreases.

For example, when the offset amount is 500 µm, the relative diffraction efficiency was 50% or less. In view of such results, a threshold value is set to deactivate the VCSEL 11 when the light intensity detected by the PD 13 becomes 50% of a predetermined value. This enables deactivation of the VCSEL 11 when the offset amount becomes 500 µm or greater, and thus meets the eye-safe limits. Notably, the eye-safe limits refer to the range of light intensity within which human eyes are less likely damaged.

The light intensity of a laser beam projected from the light source device 1 might decrease because of displacement of the light-transmissive portion 121. In some other cases, some rays might reflect off the end of the glass lid 12, turning stray light having a high light intensity. In view of such stray light, the intensity of laser beams emitted from the VCSEL 11 is to be adjusted as appropriate. The light intensity of laser beams emitted from the VCSEL 11 is adjusted using the laser beams deflected by 105.

The microstructure of the reflective DOE 122aa adjusts to even diverging laser beams having a divergence angle of above 0 degree emitted from the VCSEL 11 and incident on the reflective DOE 122aa so as to obtain the same results as described above.

Next, the operation and effect of the glass lid 12 will be described.

Optical elements such as glass lids serving as a lid of a package that houses a light-emitting element such as a laser are conventionally known. The following configuration is known: to detect fluctuations in the light intensity of the light-emitting elements due to some rays emitted from the light-emitting elements, reflected by the glass lid, and returned to the light-emitting elements, the glass lid is tilted to reflect some of a light beam emitted from a light-emitting element toward a photosensor such as a PD.

This configuration, however, causes an increase in the size of the optical device including the glass lid because of the tilt of the glass lid. For example, in a case where a distance measuring device including an optical device is mounted on, for example, a vehicle, there is a need to dispose the light source device and the distance measurement apparatus in a limited space. In view of such circumstances, such an increase in the size of the optical device is to be prevented.

In the present embodiment, the glass lid 12, which is an optical element, includes a light-transmissive portion 121 that transmits a part of the laser beam 104 emitted from the VCSEL 11 and incident thereon and a light-deflecting portion 122 that deflects a part of the incident laser beam 104.

In other words, the glass lid 12 includes a first surface 120a and a second surface 120b facing each other. The light-transmissive portion 121 is provided in at least one of the first surface 120a and the second surface 120b, and the light-deflecting portion 122 is provided in at least one of the first surface 120a and the second surface 120b. The light-transmissive portion 121 transmits and diverges a laser beam 104 incident on the light-transmissive portion 121 through the first-surface 120a side of the light-transmissive portion 121. The light-deflecting portion 122 deflects a laser beam 104 incident on the light-deflecting portion 122 through the first-surface 120a side of the light-deflecting portion 122, in a direction different from the direction of specular reflection on the first surface 120a.

The PD 13 as a photosensor receives the laser beam 105 deflected by the light-deflecting portion 122 in the glass lid 12. This configuration eliminates the need for tilting of the glass lid 12 to detect the fluctuations in the light intensity of the VCSEL 11. This provides a glass lid 12 that achieves a compact light source device 1. In the present embodiment, the light-transmissive portion 121 of the glass lid 12 has an optical property to diverge incident light beams, which reduces rays emitted from at least one light-emitting element (i.e., the VCSEL 11) and reflected from the glass lid 12 back to the at least one light-emitting element.

In the present embodiment, the light-transmissive portion 121 diverges the laser beam passing through the light-transmissive portion 121 to produce a diverging laser beam. Thus, the distance measurement apparatus 100 projects a diverging laser beam 101 transmitted through the light-transmissive portion 121.

The light source according to the present embodiment includes a VCSEL 11 as a surface-emitting laser having multiple light emitters. The VCSEL 11 includes a first light emitter 111 that emits a laser beam 103 to be incident on the light-transmissive portion 121 and transmitted therethrough and a second light emitter 112 that emits a laser beam 104 to be incident on the light-deflecting portion 122 and deflected thereby.

This configuration enables detection of a light intensity of a laser beam emitted from the VCSEL 11 without any configuration that causes some rays of a laser beam emitted from the VCSEL 11 to branch off from the laser beam. This simplifies the configuration of the light source device 1 and reduces the size of the light source device 1.

### Second Embodiment

Next, a light source device 1e according to a second embodiment will be described. Like reference signs denote like elements, and overlapping description is omitted.

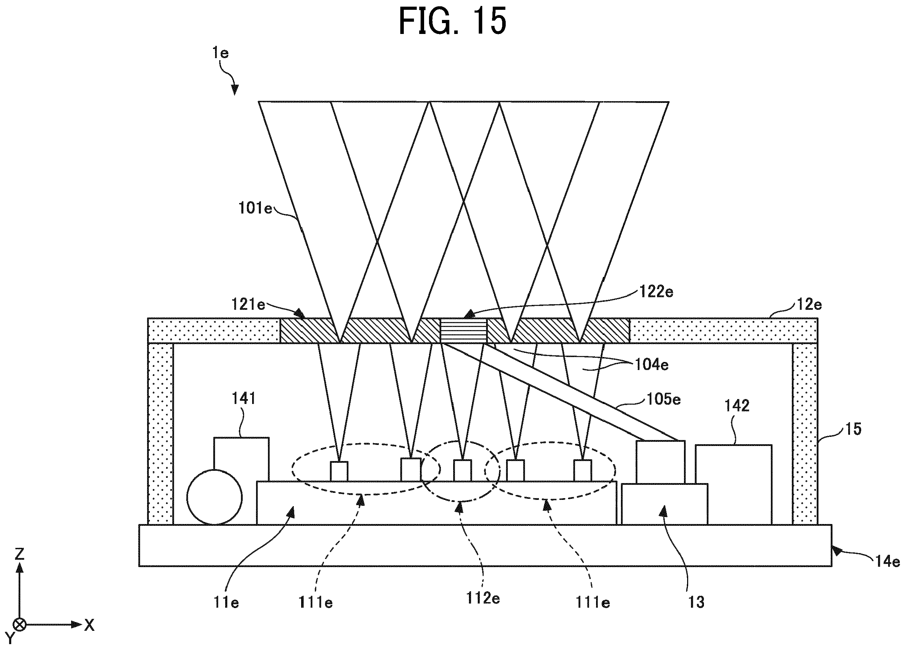

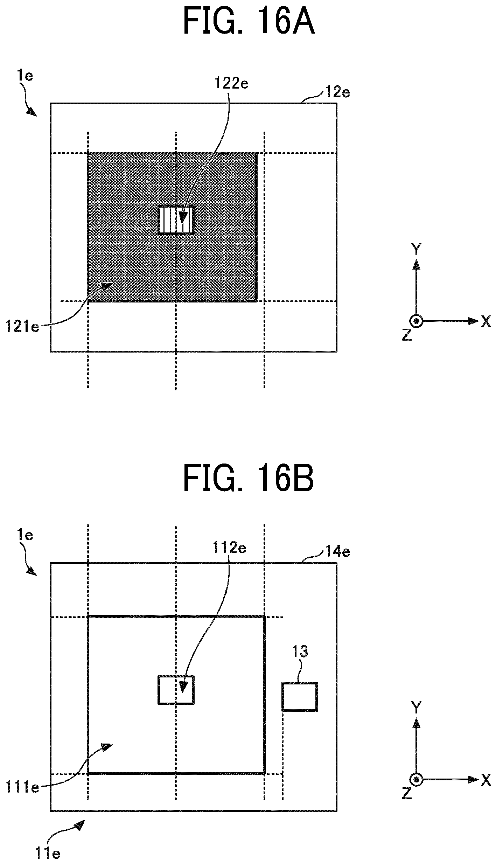

Next, the configuration of the light source device 1e will be described with reference to FIGs. 15 and 16. FIG. 15 is a cross-sectional view of an exemplary configuration of the light source device 1e. FIGs. 16A and 16B are cross-sectional views of an exemplary configuration of the light source device 1e. FIG. 16A is a plan view of a glass lid 12e, and FIG. 16B is a plan view of an electrical board 14e.

As illustrated in FIGs. 15 and 16, the light source device 1e includes the glass lid 12e and the electrical board 14e. The glass lid 12e has a light-transmissive portion 121e and a light-deflecting portion 122e. The electrical board 14e includes a VCSEL 11e including first light emitters 111e and a second light emitter 112e.

In the light source device 1e in FIG. 16A, the light-deflecting portion 122e is disposed at substantially the center of the region of the light-transmissive portion 121e. In the light source device 1e in FIG. 16B, the second light emitters 112e is disposed at substantially the center of the region of the first light emitter 111e.

More specifically, the light-transmissive portion 121e transmits and diverges incident laser beams 104e emitted from the first light emitters 111e. The laser beams 104e transmitted through the light-transmissive portion 121e is projected as a laser beam 101e from the light source device 1e. The light-deflecting portion 122e reflects and deflects a laser beam 104e emitted from the second light emitters 112e. The laser beam 105e deflected by the light-deflecting portion 122e is detected by the PD 13 to detect the light intensity of a laser beam emitted from the VCSEL 11.

In the laser beam 101e projected from the light-transmissive portion 121e, or the light source device 1e as illustrated in FIG. 15, the laser beams emitted from multiple first light emitters 111e and transmitted through the light-transmissive portion 121e overlap each other. Such a laser beam 101e has a substantially uniform light intensity within the XY plane irrespective of the arrangement of the light-deflecting portion 122e at a part of the region of the light-transmissive portion 121e.

As described above, the present embodiment includes the light-deflecting portion 122e within the region of the light-deflecting portion 122e and the second light emitters 112e within the region of the first light emitters 111e. In other words, at least two-directional sides of the light-deflecting portion 122e are surrounded by the light-transmissive portion 121e, and at least two-directional sides of the second light emitter 112e is surrounded by the first light emitters 111e. This arrangement further achieves a reduction in the size of the light source device 1e.

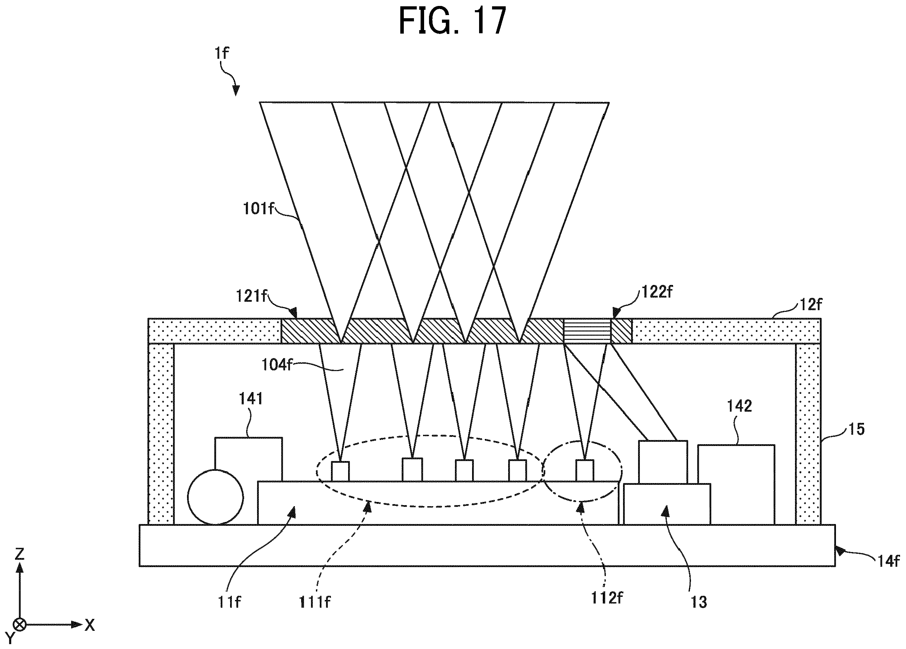

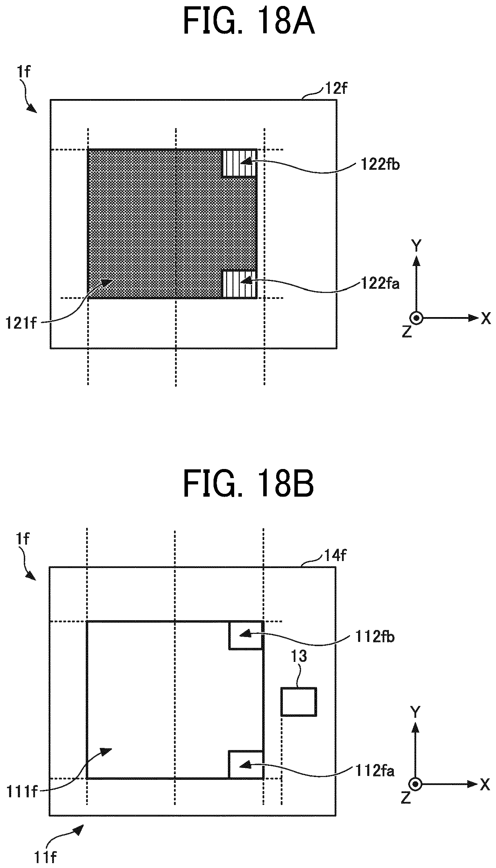

Next, the configuration of a light source device 1f according to a first variation of the second embodiment is described with reference to FIGs. 17 and 18. FIG. 17 is a cross-sectional view of an exemplary configuration of the light source device 1f. FIGs. 18A and 18B are exploded views of a configuration of a light source device 1f according to an embodiment, FIG. 18A being a plan view of a glass lid 12f and FIG. 18B being a plan view of an electrical board 14f.

As illustrated in FIGs. 17, 18A, and 18B, the light source device 1f includes the glass lid 12f and the electrical board 14f. The glass lid 12f has a light-transmissive portion 121f and light-deflecting portions 122fa and 122fb. The electrical board 14f includes a VCSEL 11f including a first light emitter 111f and second light emitters 112fa and 112fb.

The light-deflecting portion 122fa is an example of the first light deflector, and the light-deflecting portion 122fb is an example of a second light deflector. The second light emitter 112fa is an example of a second-first light emitter, and the second light emitters 112fb is an example of a second-second light emitter.

As illustrated in FIG. 18A, the light source device 1f has two light-deflecting portions 122fa and 122fb at the ends of the +X side of the region of the light-transmissive portion 121f. As illustrated in FIG. 18B, the light source device 1f has two second light emitters 112fa and 112fb at the ends of the +X side of the region of the first light emitter 111f.

The light-deflecting portion 122fa and the light-deflecting portion 122fb are arranged symmetrically with respect to the PD 13 in the Y-direction to deflect the laser beams 104f emitted from the second light emitter 112fa and the second light emitter 112fb to the PD 13, respectively.

In FIGs. 18A and 18B, the light source device 1f includes two light-deflecting portions 122fa and 122fb and two second light emitters 112fa and 112fb. This is only one example, and a light source device may include any desired number of light-deflecting portions and second light emitters.

Preferably, each of the second light emitters has a smaller area to reduce the area of the light source device 1f and also enable a laser beam 101f having a uniform light intensity within the XY plane to be projected from the light source device 1f. Further preferably, the PD 13 receives a laser beam having a light intensity sufficient to accurately detect the light intensity of the laser beam emitted from the VCSEL 11f.

The present variation enables the PD 13 to reliably receive a laser beam having a light intensity sufficient for the accurate detection of the light intensity of the VCSEL 11f by incorporating multiple second light emitters 112fa and 112fb without an increase in the area of the light source device 1f, and thus achieves the accuracy of detection of the light intensity of a laser beam emitted from the VCSEL 11f by the PD 13.

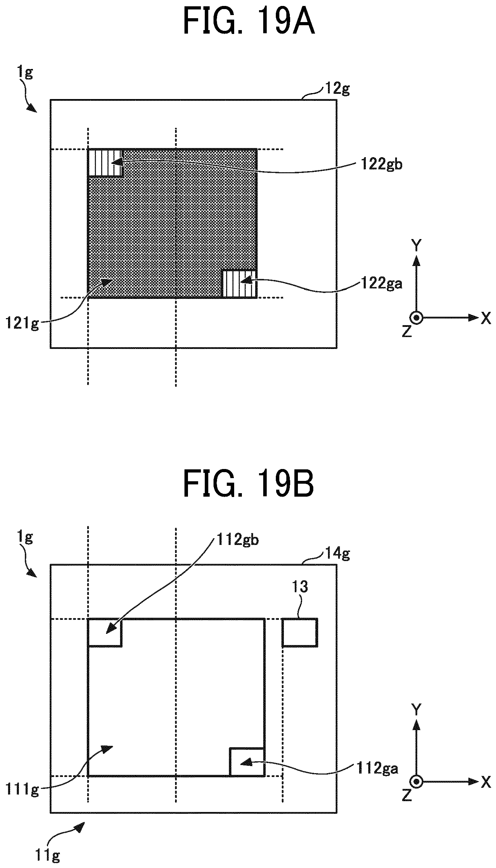

Next, the configuration of a light source device 1g according to a second variation of the second embodiment is described with reference to FIGs. 19A and 19B. FIGs. 19A and 19B are exploded views of a configuration of a light source 1g device according to an embodiment, FIG. 19A being a plan view of a glass lid 12g and FIG. 19B being a plan view of an electrical board 14g.

As illustrated in FIGs. 19A and 19B, the light source device 1g includes the glass lid 12g and the electrical board 14g. The glass lid 12g has a light-transmissive portion 121g and light-deflecting portions 122ga and 122gb. The electrical board 14g includes a VCSEL 11g including a first light emitter 111g and second light emitters 112ga and 112gb.

As illustrated in FIG. 19A, the light source device 1g has two light-deflecting portions 122ga and 122gb at diagonal positions of the region of the light-transmissive portion 121g within the XY plane. As illustrated in FIG. 19B, the light source device 1g has two second light emitters 112ga and 112gb at diagonal positions of the region of the first light emitter 111g within the XY plane.

In a plan view, a line segment connecting the second light emitter 112ga and the PD 13 and a line segment connecting the second light emitter 112gb and the PD 13 are substantially orthogonal to each other. However, as the second light emitters 112ga and 112gb are within the region of the first light emitter 111g, the angle between the line segment connecting the second light emitter 112ga and the PD 13 and the line segment connecting the second light emitter 112gb and the PD 13 is smaller than the right angle.

To enable one PD 13 to receive the laser beams emitted from the two second light emitters 112ga and 112gb, respectively, the DOE of the light-deflecting portion 122gb has a DOE pattern, which is rotated by substantially 90 degrees from the DOE pattern of the light-deflecting portion 122ga.

The present variation enables an efficient correction of the tilt (i.e., rolling) of the glass lid 12g and the electrical board 14g within the XY plane to maximize the light intensity of the laser beam to be received by the PD 13 during a fine-adjustment of the relative position of the glass lid 12g and the electrical board 14g after fixing the glass lid 12g to the light source device 1g.

### Third Embodiment

Next, a light source device 1g according to a third embodiment will be described.

The laser beam in which energy is spatially concentrated at high density is harmful to human eyes when emitted to space where a human is present and incident on the human eyes while maintaining its high energy. To deal with such an issue, any light source device preferably satisfies the eye-safe standard for characteristics such as an output, a pulse width, a wavelength, and a divergence angle of an emitted laser beam to keep the human eyes safe.

The light source device 1g according to the present embodiment is an eye-safe device that emits laser beams within the range of the eye-safe standard by regulating the pulse widths and outputs of the laser beams emitted from the VCSEL 11 while diverging the laser beam by the light-transmissive portion 121 sufficiently to obtain intended levels.

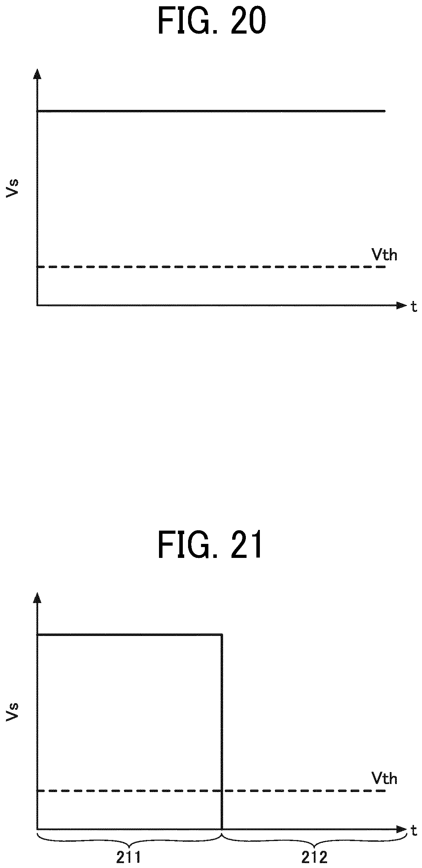

The light source device 1g includes a light-deflecting portion 122 that reflects a laser beam emitted from the VCSEL 11 to the light-receptive surface 131 of the PD 13. When the glass lid 12 including the light-deflecting portion 122 is disposed at an appropriate position with respect to the VCSEL 11, the laser beam deflected by the light-deflecting portion 122 is guided to the PD 13 so that the PD 13 detects the light intensity of the laser beam. This is referred to as a regular operation mode. FIG. 20 is an illustration of a change in voltage Vs detected by the PD 13 during the regular operation mode of the light source device 1.

In FIG. 20, the voltage Vs detected by the PD 13 refers to a signal voltage into which the light intensity detected by the PD 13 is photoelectrically converted. A threshold voltage Vth is a threshold value used to stop applying power to the VCSEL 11. In the light source device 1g, applying power to the VCSEL 11 is stopped when the voltage Vs falls below the threshold voltage Vth. In other words, the controller 3 controls the drive unit 2 to deactivate the VCSEL 11 in a case that the voltage Vs (an output) from the PD 13 is below the threshold value Vs.

The threshold voltage Vth is set to below the voltage Vs with the glass lid 12 disposed at a desired position relative to the VCSEL 11 during the regular operation mode. The threshold voltage Vth is set to below the voltage Vs, which is obtained when light emitted from the VCSEL 11 is sufficiently diverged by the light-transmissive portion 121, and light with a sufficient intensity is deflected by the light-deflecting portion 122 to the PD 13. The threshold voltage Vth is determined as appropriate by the user according to the use environment and use application of the light source device 1g.

Preferably, the threshold voltage Vth is, for example, substantially 10% or greater and substantially 50% or less of the voltage Vs. Setting the threshold voltage Vth to substantially 10% or greater of the voltage Vs prevents or reduces an erroneous operation, which is caused by disturbance light such as sunlight and light of indoor lighting incident on the PD 13 due to coming off of the glass lid 12 in the light source device. Setting the threshold voltage Vth to substantially 50% or less of the voltage Vs allows the light source device 1g to deactivate the VCSEL 11 to stop light emission in response to detection of a decrease in the light intensity received by the PD 13 due to the displacement of the glass lid 12. This improves safety of the light source device 1g. Further, the light source device 1g stops applying power to the VCSEL 11 in response to detection of fluctuations in the light intensity of light emitted from the VCSEL 11 due to heat generated by the light emitters of the VCSEL 11, so as to prevent an erroneous operation.

Preferably, the voltage Vs is continuously detected during the light emission of the VCSEL 11 to continue satisfying the eye-safe standard.

The glass lid 12 including the light-transmissive portion 121 and the light-deflecting portion 122 is not disposed at a desired position relative to the VCSEL 11 because of coming off or breakdown of the glass lid 12 in the light source device. This case is referred to as an abnormal operation mode. During the abnormal operation mode of the light source device, light emitted from the VCSEL 11 fails to strike the light-transmissive portion 121 appropriately and travels into space where a human is present without being diverged. In this case, as the light source device 1g fails to satisfy the eye-safe standard, the VCSEL 11 is preferably deactivated. In the present embodiment, the VCSEL 11 is deactivated based on the threshold voltage Vth.

In the light source device 1g, the light intensity received by the light-receptive surface 131 of the PD 13 decreases according to an offset of the light-deflecting portion 122 due to the displacement of the glass lid 12 as illustrated in FIGs. 14A and 14B. FIG. 21 is an illustration of a change in voltage Vs detected by the PD 13 during the abnormal operation mode of the light source device 1g.

As illustrated in FIG. 21, the voltage Vs detected by the PD 13 exceeds the threshold voltage Vth in the period 211 of the regular operation mode in which the glass lid 12 is disposed at a desired position. In contrast, the voltage Vs detected by the PD 13 decreases with a reduction in the light intensity received by the PD 13 and falls below the threshold voltage Vth in the period 212 of the abnormal operation mode in which the glass lid 12 comes off from the desired position in the light source device. In response to detection of the voltage Vs of below the threshold voltage Vth, which is caused by displacement of the glass lid 12, the light source device 1g deactivates the VCSEL 11 to stop light emission. This eye-safe light source device 1g satisfies the eye-safe standard in any situation and increases its safety.

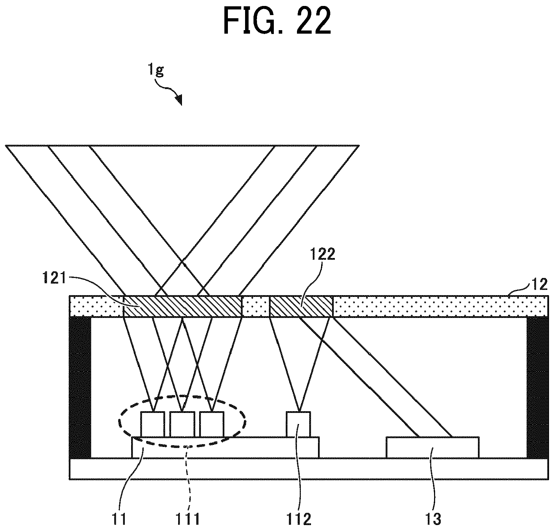

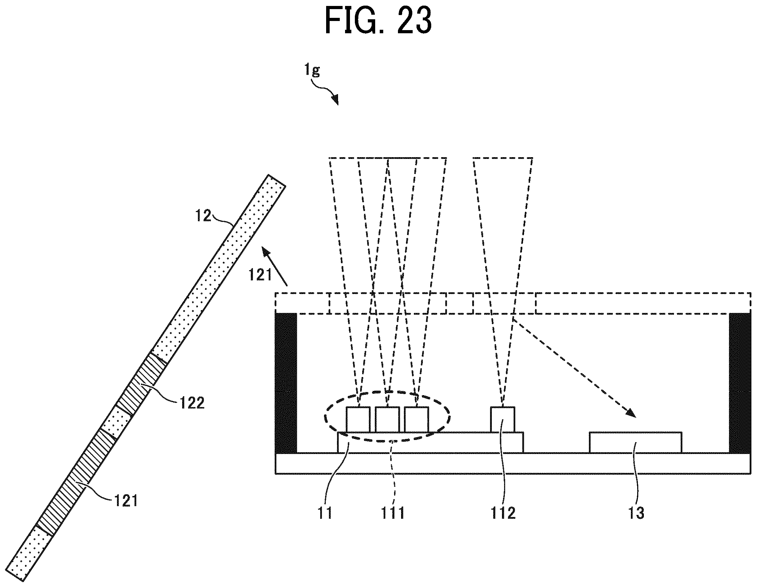

FIG. 22 is an illustration of divergence of laser beams emitted from the light source device 1g during the regular operation mode. FIG. 23 is an illustration of divergence of light beams emitted from the light source device 1g during the abnormal operation mode. As illustrated in FIG. 22, the light source device 1g diverges light beams emitted from the VCSEL 11 and emits diverging light beams during the regular operation mode. The PD 13 appropriately detects the light intensity of light striking the PD 13. As illustrated in FIG. 23, the light source device 1g fails to diverge laser beams emitted from the VCSEL 11 and emits narrow-angle laser beams having a high energy when the glass lid 12 comes off from the desired position in the light source device 1g. Such a light source device may fail to satisfy the eye-safe standard and provide insufficient safety.

The light source device 1g deactivates the VCSEL 11 to stop light emission in response to detection that the voltage Vs falls below the threshold voltage Vth with a decrease in the light intensity detected by the PD 13. This configuration enables the light source device 1g to satisfy the eye-safety standard irrespective of the case in which the glass lid 12 comes off from the desired position in the light source device 1g and provides a light source device 1g with a high level of safety.

### Fourth Embodiment

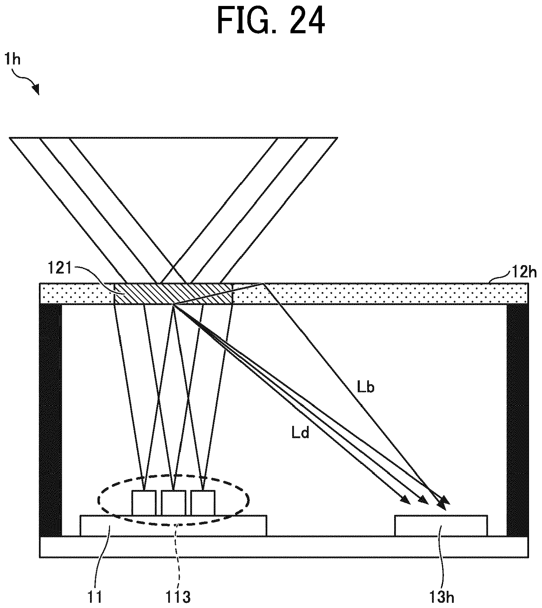

FIG. 24 is an illustration of a light source device 1h with a glass lid 12h including a light-deflecting portion that and reflects and deflects incident light. As illustrated in FIG. 24, the light source device 1h includes the glass lid 12h and a PD 13h. The glass lid 12h includes a light-transmissive portion 121 without any light-deflecting portion having a particular structure such as microlenses, a microstructure, and a transmissive DOE as illustrated in FIGs. 8A to 8F. At least one of the light-transmissive portion 121 and the second surface 120b reflects and deflects light.

The PD 13h receives stray light including diffuse reflection light Ld diffused and reflected by the light-transmissive portion 121 and reflection light Lb reflected by the second surface 120b and detects a light intensity of the received light. The diffuse reflection light Ld is light emitted from a light emitter 113 including multiple light-emitting elements in the VCSEL 11, incident on the light-transmissive portion 121 having a diffuse structure, and then reflected by the light-transmissive portion 121 without being transmitted through the light-transmissive portion 121. The reflection light Lb is light emitted from the light emitter 113 of the VCSEL 11, incident on the light-transmissive portion 121, diverged by the light-transmissive portion 121, and then reflected by the second surface 120b (i.e., the opposite surface of the surface (i.e., the first surface 120a) facing the VCSEL 11) of the glass lid 12h. In the light source device 1h according to the present embodiment, at least one of the light-transmissive portion 121 and the second surface 120b of the glass lid 12h serves as a light-deflecting portion.

The light source device 1h detects the light intensity of a laser beam emitted from the VCSEL 11 by detecting the diffuse reflection light Ld and the reflection light Lb, which eliminates the need for the glass lid 12h to have any structure that deflects light. This configuration without such a structure in the glass lid 12h simplifies the configuration of the light source device 1g.

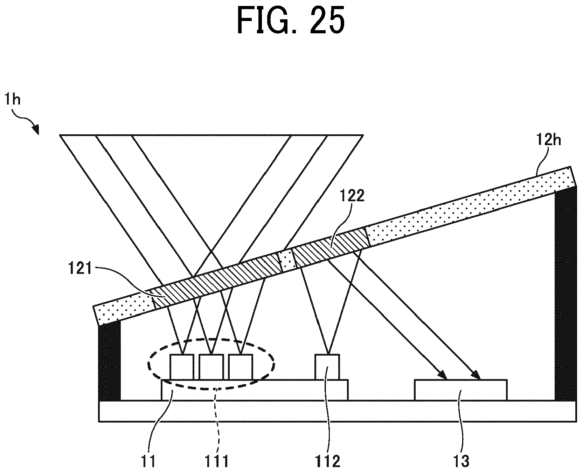

FIG. 25 is an illustration of a light source device 1h according to a first variation of the fourth embodiment. In the light-transmissive portion 121h according to the first variation of the fourth embodiment, the glass lid 12h with the first surface 120a serving as a light-deflecting portion and the light-transmissive portion 121 is tilted relative to the light-emitting elements, and the PD receives light reflected and deflected by the first surface 120a. The glass lid 12h is tilted relative to the light-emitting elements so that light reflected by the first surface 120a serves as light deflected by the first surface 120a. In other words, the first surface 120a reflects some rays of light incident on the first surface 120a to deflect the rays in the direction of specular reflection on the first surface 120a. The first surface 120a serves as a light-deflecting portion.

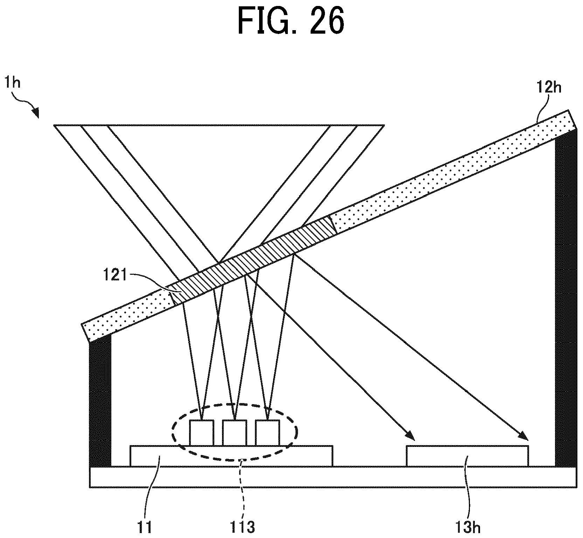

FIG. 26 is an illustration of a light source device 1h according to a second variation of the fourth embodiment. In the light-transmissive portion 121h according to the second variation of the fourth embodiment, the glass lid 12h has a divergence structure on the second-surface 120b side of the glass lid 12h as illustrated in FIGs. 8A to 8C. The glass lid 12h is tilted relative to the VCSEL 11 to have the first surface 120a serving to reflect incident light to deflect the light to the PD 13. In the present variation, multiple light-emitting elements of the light emitter 113 are not categorized into the first light emitter 111 and the second light emitter 112 as illustrated in FIG. 26. Some rays of light emitted from the light emitter 113 are reflected by the first surface 120a, turning deflected light, and other rays of the light emitted from the light emitter 113 are transmitted through the first surface 120a, turning transmitted light. In this example, the light emitter 113 serves as both the first light emitter 111 and the second light emitter 112, and the first surface 120a serves as a light-deflecting portion. The first and second variations of the fourth embodiment simplify the configuration of the glass lid 12h in the same manner as in the fourth embodiment in FIG. 24 and allows light emitted from the VCSEL 11 to strike the PD 13 more reliably, thus increasing the efficiency of light reception by the PD 13 more than the fourth embodiment although the first and second variations fail to prevent upsizing of the light source device because of the tile of the glass lid 12h.

### Fifth Embodiment

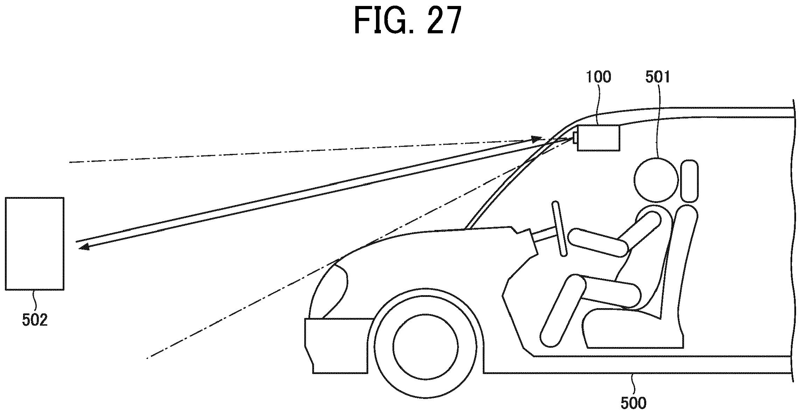

Next, a fifth embodiment will be described. The fifth embodiment relates to a mobile object. FIG. 27 is an illustration of a vehicle as a mobile object according to a fifth embodiment. A vehicle 500 as an example of a mobile object according to the fifth embodiment is mounted with a distance measurement apparatus 100 at an upper portion of the windshield. The distance measurement apparatus 100 measures a distance to an object 502 around the vehicle 500. The measurement result of the distance measurement apparatus 100 is input to a mobile-object controller included in the vehicle 500, and the mobile-object controller controls the operation of the mobile object based on the measurement result. Alternatively, the mobile-object controller displays a warning on a display provided in the vehicle 500 for the driver 501 of the vehicle 500 based on the measurement result of the distance measurement apparatus 100.

The vehicle 500 mounted with the distance measurement apparatus 100 according to the fifth embodiment enables an accurate awareness of position of an object 502 around the vehicle 500. The installation position of the distance measurement apparatus 100 is not limited to an upper and front portion of the vehicle 500, and the distance measurement apparatus 100 may be mounted at a side surface or a rear portion of the vehicle 500. In this example, the distance measurement apparatus 100 is provided in the vehicle 500. Alternatively, the distance measurement apparatus 100 may be provided in an aircraft or a ship. Still alternatively, the distance measurement apparatus 100 may be provided in mobile objects such as drones and robots that autonomously move without a driver.

Numerous additional modifications and variations are possible in light of the above teachings. It is therefore to be understood that within the scope of the appended claims, the disclosure of the present disclosure may be practiced otherwise than as specifically described herein. For example, elements and/or features of different illustrative embodiments may be combined with each other and/or substituted for each other within the scope of this disclosure and appended claims.

Notably, light projected by the light source device is not limited to a laser beam and may be a laser beam without directionality or an electromagnetic wave having a long wavelength to be used in a radar.

In addition, the numbers such as ordinal numbers and quantities used above are all examples for specifically describing the technology of the present invention, and the present invention is not limited to the exemplified numbers. In addition, the relation of connection between the components are illustrated for specifically describing the technology of the present invention, and the relation of connection for implementing the function of the present disclosure is not limited thereto.

The above-described embodiments are illustrative and do not limit the present invention. Thus, numerous additional modifications and variations are possible in light of the above teachings. For example, elements and/or features of different illustrative embodiments may be combined with each other and/or substituted for each other within the scope of the present invention.

Any one of the above-described operations may be performed in various other ways, for example, in an order different from the one described above.

The present invention can be implemented in any convenient form, for example using dedicated hardware, or a mixture of dedicated hardware and software. The present invention may be implemented as computer software implemented by one or more networked processing apparatuses. The processing apparatuses include any suitably programmed apparatuses such as a general purpose computer, a personal digital assistant, a Wireless Application Protocol (WAP) or third-generation (3G)-compliant mobile telephone, and so on. Since the present invention can be implemented as software, each and every aspect of the present invention thus encompasses computer software implementable on a programmable device. The computer software can be provided to the programmable device using any conventional carrier medium (carrier means). The carrier medium includes a transient carrier medium such as an electrical, optical, microwave, acoustic or radio frequency signal carrying the computer code. An example of such a transient medium is a Transmission Control Protocol/Internet Protocol (TCP/IP) signal carrying computer code over an IP network, such as the Internet. The carrier medium may also include a storage medium for storing processor readable code such as a floppy disk, a hard disk, a compact disc read-only memory (CD-ROM), a magnetic tape device, or a solid state memory device.

## Claims

1. An optical element (12) comprising:
a first surface (120a); and
a second surface (120b) facing the first surface (120a);
a light-transmissive portion (121) to transmit and diverge a light beam incident on the light-transmissive portion (121) from outside of the first surface (120a) to emit a diverging light beam to outside of the second surface (120b); and
a light-deflecting portion (122) to deflect a light beam incident on the first surface (120a) from the outside of the first surface (120a), in a direction different from a direction of specular reflection on the first surface (120) outside the first surface (120a).

2. The optical element (12) according to claim 1,
wherein the light-deflecting portion (122) deflects a part of the laser beam incident on the light-deflecting portion (122) by at least one of diffraction, diffusion, and refraction.

3. The optical element (12) according to claim 1 or 2,
wherein the light-transmissive portion (121) diverges a part of the light beam incident on the light-transmissive portion (121) by at least one of diffraction, diffusion, and refraction.

4. The optical element (12) according to any one of claims 1 to 3,
wherein the light-transmissive portion (121) is included in at least one of the first surface (120a) and the second surface (120b), and
wherein the light-deflecting portion (122) is included in at least one of the first surface (120a) and the second surface (120b).

5. An optical device (1) comprising:
the optical element (12) according to any one of claims 1 to 4;
a light source (11) to emit light to the optical element (12); and
a photosensor (13) to detect the light emitted from the light source (11) and deflected by the light-deflecting portion (122).

6. The optical device (1) according to claim 5,
wherein the light source (11) is any one of a surface-emitting laser, an edge-emitting laser, and a light-emitting diode.

7. The optical device (1) according to claim 5 or 6,
wherein the light source (11) is a surface-emitting laser including multiple light-emitting elements (11-1 to 11-n), and
wherein the multiple light-emitting elements (11-1 to 11-n) include:
a first light emitter (111) to emit light to be transmitted through the light-transmissive portion (121); and
a second light emitter (112) to emit light to be deflected by the light-deflecting portion (122).

8. The optical device (1) according to claim 7,
wherein the light-deflecting portion (122) has at least two-directional sides surrounded by the light-transmissive portion (121), and
wherein the second light emitter (112) has at least two-directional sides surrounded by the first light emitter (111).

9. The optical device (1) according to claim 7 or 8,
wherein the second light emitter (112) includes a second-first light emitter (112fa) and a second-second light emitter (112fb),
wherein the light-deflecting portion (122) includes a first light-deflecting portion (122fa) and a second light-deflecting portion (122fb),
wherein the first light-deflecting portion (122fa) deflects a part of incident light emitted from the second-first light emitter (112fa), and the second light-deflecting portion (122fb) deflects a part of incident light emitted from the second-second light emitter (112fb), and
wherein the photosensor (13) detects each of the light deflected by the first light-deflecting portion (122fa) and the light deflected by the second light-deflecting portion (122fb).

10. The optical device (1) according to any one of claims 5 to 9, further comprising:
a driver (2) to drive the light source (11); and
a controller (3) to:
obtain an output from the photosensor (13); and
control the driver (2),
wherein the controller (3) controls the driver (2) to stop emitting light in a case that an output from the photosensor (13) is below a threshold value.

11. A distance measurement apparatus (100) comprising:
the optical device (1) according to any one of claims 5 to 10 to emit light to an obj ect;
a photosensor (4) to receive light reflected from the object; and
a distance acquisition unit (6) to obtain a distance to the object based on the light emitted to the object and the light received from the object.

12. A mobile object (500) comprising the distance measurement apparatus (100) according to claim 11.
